# EUROPEAN PATENT APPLICATION

(11) **EP 4 571 972 A1**
(43) Date of publication of application: **18.06.2025**
(21) Application number: 24216590.0
(22) Date of filing: 29.11.2024
(51) Int. Cl.: H01M 50/209, H05K 7/14, H05K 7/18

(54) **CABINET DESIGN FOR HEAVY BATTERY OR EQUIPMENT APPLICATIONS**

(30) Priority: 12.12.2023 US 202363609214 P; 25.11.2024 US 202418959067
(71) Applicant: Vertiv Corporation, Westerville, OH 43082 (US)
(72) Inventor: ELKINS, Jin H., Westerville, 43082 (US); MALONEY, Jerome A., Westerville, 43082 (US); PODEMSKI, Matthew A., Westerville, 43082 (US)
(74) Representative: Bryn-Jacobsen, Caelia

(57) **Abstract**

A cabinet may include a left side panel comprising: a left outer side wall comprising an inside surface, a left inner side wall disposed adjacent to the inside surface of the left outer side wall, a left front shelf support channel, a left rear shelf support channel, wherein floor ends of the left front shelf support channel and the left rear shelf support channel comprise a channel connector, wherein the left front shelf support channel and the left rear shelf support channel are: fastened to the left inner side wall via fasteners; and adhered to the left inner side wall via an adhesive, a right side panel comprising a right front support channel and a right rear support channel, and at least one shelf secured by the left front shelf support channel, the left rear shelf support channel, the right front support channel, and the right rear support channel.

## Description

### CROSS-REFERENCE TO RELATED APPLICATIONS

The present application claims priority to U.S. Provisional Patent Application Number 63/609,214, filed December 12, 2023.

### TECHNICAL FIELD

The present disclosure relates to cabinets for housing batteries, and more particularly for cabinets for housing heavy batteries that meet specific seismic requirements.

### BACKGROUND

Telecommunication and computing industries rely heavily on electrical equipment that is required to be in use continuously, which requires backup battery resources. Backup batteries for telecommunication and cloud computing systems are often heavy, and cabinets storing these batteries must be able to withstand not only storing hundreds to thousands of kilograms of batteries safely, but must do so while satisfying environmental (e.g., earthquake) regulations, such as Telcordia^{®} GR-487 Zone 4 seismic requirements. Accordingly, it may be advantageous to have a system (e.g., a cabinet) that can safely store heavy batteries while meeting seismic regulation requirements.

### SUMMARY

In some examples, the techniques described herein relate to an electronic equipment cabinet for supporting electronic equipment including: a left side panel including: a left outer side wall including an inside surface; a left inner side wall disposed adjacent to the inside surface of the left outer side wall; a left front shelf support channel; a left rear shelf support channel, wherein floor ends of the left front shelf support channel and the left rear shelf support channel include a channel connector, wherein the left front shelf support channel and the left rear shelf support channel are: fastened to the left inner side wall via fasteners; and adhered to the left inner side wall via an adhesive; a right side panel including a right front support channel and a right rear support channel; at least one shelf secured by the left front shelf support channel, the left rear shelf support channel, the right front support channel, and the right rear support channel; a cabinet floor; a forward front floor cross bracket; a forward rear floor cross bracket, wherein the forward front floor cross bracket and the forward rear floor cross bracket are fastened to the cabinet floor with fasteners and adhered to the cabinet floor via the adhesive, wherein each end of the forward front floor cross bracket and the forward rear floor cross bracket include bracket connectors, the bracket connectors including: at least two fastener connection points positioned along a first direction relative to the forward front floor cross bracket and the forward rear floor cross bracket; and at least two fastener connection points positioned along a second direction relative to the forward front floor cross bracket and the forward rear floor cross bracket, wherein the at least two fastener connection points positioned along the first direction and the at least two fastener connection points positioned along the second direction are couplable to a respective channel connector via the fasteners, wherein the bracket connectors and the channel connector are coupled via the fasteners and the adhesive; a back panel; and a door frame.

In some examples, the electronic equipment cabinet is configured to pass tests consistent with GR-487 Seismic Zone 4 requirements.

In some examples, the techniques described herein relate to an electronic equipment cabinet for supporting electronic equipment including: a left side panel including: a left outer side wall including an inside surface; a left inner side wall disposed adjacent to the inside surface of the left outer side wall; a left front shelf support channel; a left rear shelf support channel, wherein floor ends of the left front shelf support channel and the left rear shelf support channel include a channel connector, wherein the left front shelf support channel and the left rear shelf support channel are fastened to the left inner side wall via fasteners; a right side panel including a right front support channel and a right rear support channel; at least one shelf secured by the left front shelf support channel, the left rear shelf support channel, the right front support channel, and the right rear support channel; a cabinet floor; a forward front floor cross bracket; and a forward rear floor cross bracket, wherein the forward front floor cross bracket and the forward rear floor cross bracket are fastened to the cabinet floor via fasteners, wherein each end of the forward front floor cross bracket and the forward rear floor cross bracket include bracket connectors, the bracket connectors including: at least two fastener connection points positioned along a first direction relative to the forward front floor cross bracket and the forward rear floor cross bracket; and at least two fastener connection points positioned along a second direction relative to the forward front floor cross bracket and the forward rear floor cross bracket, wherein the at least two fastener connection points positioned along the first direction and the at least two fastener connection points positioned along the second direction are couplable to a respective channel connector via the fasteners, wherein the bracket connectors and the channel connector are coupled via the fasteners.

In some examples, the techniques described herein relate to a method for constructing an electronic equipment cabinet including: assembling shelf support channels to inner side walls of the electronic equipment cabinet; assembling cross brackets, wherein the cross brackets are arranged to form a clamp around the shelf support channels; and adhering at least one cross bracket to a cabinet floor via an adhesive.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE FIGURES

The detailed description is described with reference to the accompanying figures. The use of the same reference numbers in different instances in the description and the figures may indicate similar or identical items. Various examples or examples ("examples") of the present disclosure are disclosed in the following detailed description and the accompanying drawings. The drawings are not necessarily to scale. In general, operations of disclosed processes may be performed in an arbitrary order, unless otherwise provided in the claims.
FIG. 1 illustrates a front perspective view of an electronic equipment cabinet storing battery strings, in accordance with one or more examples of the disclosure.
FIG. 2 illustrates a front perspective view of an electronic equipment cabinet, in accordance with one or more examples of the disclosure.
FIG. 3 illustrates a rear perspective view of an electronic equipment cabinet, in accordance with one or more examples of the disclosure.
FIG. 4 illustrates a close-up front perspective view of a lower-left corner of the electronic equipment cabinet, in accordance with one or more examples of the disclosure.
FIG. 5 illustrates a further close-up front perspective view of a lower-left corner of the electronic equipment cabinet of FIG. 4, in accordance with one or more examples of the disclosure.
FIG. 6 illustrates a close-up view of a coupling between a left front shelf support channel and a forward floor cross bracket set of the electronic equipment cabinet. In accordance with one or more examples of the disclosure.
FIG. 7 illustrates an isolated perspective view of a left front shelf support channel, in accordance with one or more examples of the disclosure.
FIG. 8 illustrates an isolated perspective view of a front cross floor bracket and a rear cross floor bracket, in accordance with one or more examples of the disclosure.
FIG. 9A illustrates a perspective view of a lower half of the electronic equipment cabinet, in accordance with one or more examples of the disclosure.
FIG. 9B illustrates an isolated perspective view of a rear stiffening bracket, in accordance with one or more examples of the disclosure.
FIG. 10A illustrates a perspective view of a lower half of the electronic equipment cabinet, with a rear panel removed, in accordance with one or more examples of the disclosure.
FIG. 10B illustrates an isolated perspective view of a front corner bracket of the electronic equipment cabinet, in accordance with one or more examples of the disclosure.
FIG. 11 illustrates a partially exploded front perspective view of the electronic equipment cabinet and a plinth, in accordance with one or more examples of the disclosure.
FIG 12 illustrates a perspective underside view of the electronic equipment cabinet, in accordance with one or more examples of the disclosure.
FIG. 13 illustrates a partially exploded front perspective view of the electronic equipment cabinet, in accordance with one or more examples of the disclosure.
FIG. 14 illustrates a flow chart depicting a method for constructing the electronic equipment cabinet, in accordance with one or more examples of the disclosure.

### DETAILED DESCRIPTION

Before explaining one or more examples of the disclosure in detail, it is to be understood that the examples are not limited in their application to the details of construction and the arrangement of the components or steps or methodologies set forth in the following description or illustrated in the drawings. In the following detailed description of examples, numerous specific details may be set forth in order to provide a more thorough understanding of the disclosure. However, it will be apparent to one of ordinary skill in the art having the benefit of the instant disclosure that the examples disclosed herein may be practiced without some of these specific details. In other instances, well-known features may not be described in detail to avoid unnecessarily complicating the instant disclosure.

As used herein a letter following a reference numeral is intended to reference an example of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present), and B is false (or not present), A is false (or not present) and B is true (or present), and both A and B are true (or present).

In addition, the use of "a" or "an" may be employed to describe elements and components of examples disclosed herein. This is done merely for convenience and "a" and "an" are intended to include "one" or "at least one," and the singular also includes the plural unless it is obvious that it is meant otherwise.

Finally, as used herein any reference to "one example" or "examples" means that a particular element, feature, structure, or characteristic described in connection with the example is included in at least one example disclosed herein. The appearances of the phrase "in examples" in various places in the specification are not necessarily all referring to the same example, and examples may include one or more of the features expressly described or inherently present herein, or any combination or sub-combination of two or more such features, along with any other features which may not necessarily be expressly described or inherently present in the instant disclosure.

Disclosed is an electronic equipment cabinet for storing heavy electronic equipment (e.g., up to, and/or over, 2600 pounds, (1180 kilograms) of electronic equipment). The electronic equipment cabinet includes side panels with inner side walls that are fastened to shelf support channels. The electronic equipment cabinet further includes a cabinet floor, and cross brackets fastened to the cabinet floor. The cross brackets include bracket connectors that couple to channel connectors of the shelf support channels. The bracket connectors include two sets of connection points arranged in both a first direction and a second direction relative to the cross brackets that are used to couple to the channel connectors. The electronic equipment cabinet uses both fasteners and adhesives, which enable the electronic equipment cabinet to support heavy weight while passing seismic and vibration tests in order to satisfy safety regulations, such as the Telcordia GR-487 Zone 4 seismic requirements. The electronic equipment cabinet includes several components that are linked with both fasteners, such as M6 fasteners, and adhesive. The design of the electronic equipment cabinet, along with the use of fasteners and adhesive allows the electronic equipment cabinet to be constructed without the use of "Zone 4 Frame Weldment". Zone 4 Frame Weldment is an expensive, material-intensive process that requires difficult fabrication steps and is difficult to modify, often resulting in long lead times, generation of scrap, ordering logistic issues, and a non-flexible design such that implementing any changes is a long and cumbersome process.

As described above, the electronic equipment cabinet utilizes structural adhesive, such as in the critical internal areas of the electronic equipment cabinet, to provide augmented strength and rigidity over mechanical fasteners alone. The application of structural adhesive is easier and more flexible than most welding process in difficult-to-reach internal areas of the electronic equipment cabinet. Welding is often not a viable manufacturing option in hard-to-reach areas.

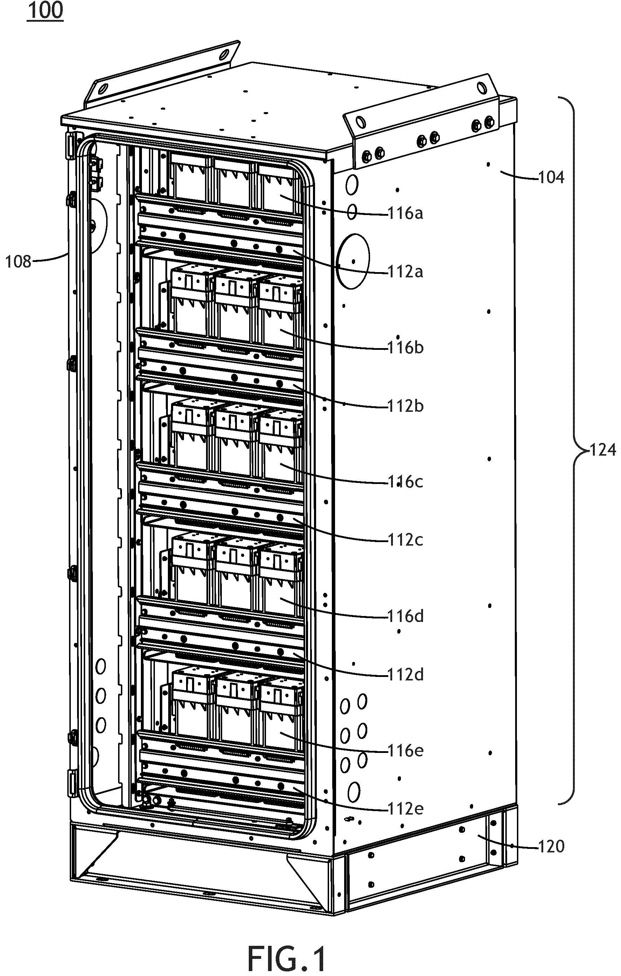

In examples, as illustrated in FIG. 1, an electronic equipment cabinet 100 is presented. The electronic equipment cabinet 100 includes a left side panel 104, a right side panel 108, and one or more shelves 112a-e. The one or more shelves 112a-e are configured to support battery strings 116a-e, such as valve regulated lead-acid (VRLA) battery strings. The one or more shelves 112a-e may include or incorporate internal cabinet battery shelf support structures that couple to the battery strings 116a-e.

The electronic equipment cabinet 100 may include any size or dimension to support any number of shelves 112a-e or battery strings 116a-e. For example, the electronic equipment cabinet 100 may include 2, 3, 4, 5, 6, 7, 10, or 20 or more shelves 112. For instance, the electronic equipment cabinet 100 may include five shelves 115a-e. Battery strings 116 can weigh over 500 pounds (e.g., approximately 225 kilograms). Therefore, the electronic equipment cabinet100 may be configured to support over 1000 pounds (450 kilograms), over 1500 pounds (680 kilograms), over 2000 pounds (900 kilograms), over 2500 kilograms (1130 kilograms), 2600 or more pounds (1180 or more kilograms, or over 3000 pounds (1360 kilograms). For example, the electronic equipment cabinet 100 may be configured to support 2600 pounds (1180 kilograms).

The electronic equipment cabinet 100 may be constructed of any size or dimension necessary for the storage of electronic equipment. For example, the electronic equipment cabinet 100 may be configured to support at least one battery string 116 and have dimensions of at least 21 inches of width, 22 inches of depth, and 13 inches of height (e.g., dimensions for storing an example battery string 116). In another example, the electronic equipment cabinet 100 may be configured to support at least three battery strings 116a-c and have dimensions of at least 32 inches of width, 32 inches of depth, and 60 inches of height. In another example, the electronic equipment cabinet 100 may be configured to support at least three battery strings 116a-e and have dimensions of at least 32 inches of width, 32 inches of depth, and 78 inches of height. In another example, the electronic equipment cabinet 100 may be configured to support at least three battery strings 116a-c and have dimensions of at least 32 inches of width, 32 inches of depth, and 60 inches of height. In another example, the electronic equipment cabinet 100 may be configured to support at least three battery strings 116a-e and have dimensions of at least 32 inches of width, 32 inches of depth, and 72 inches of height. Therefore, the dimensions of the electronic equipment cabinet 100 are not limited to the demonstrated examples.

In examples, the electronic equipment cabinet 100 is configured to pass one or more tests consistent with, or satisfying, seismic safety requirements (e.g., protection from earthquakes). The test may include seismic-based and vibration-based tests. The seismic safety requirements may include requirements from any safety organization including, but not limited to, government-based, or industry-based safety organizations. For example, the seismic safety requirements may include GR-487 Seismic Zone 4 requirements (e.g., as found in the latest published Telcordia GR-487 standards as of 2023). For instance, the electronic equipment cabinet 100 may be designed to meet the physical performance and functional criteria (e.g., pass physical performance and functional criteria tests) for earthquake resistance outlined in, and in accordance with, Telcordia GR-63 Sections 4.4.1.2 (Seismic: Mechanical tests) and 4.4.1.3 (Seismic: Operability tests) (e.g., as found in the latest published Telcordia GR-63 standards as of 2023).

In examples, the electronic equipment cabinet 100 includes a plinth 120 (e.g., a base) supporting a main cabinet section 124 of the electronic equipment cabinet 100. The plinth 120 may be constructed with width and depth dimensions similar to the main cabinet section 124. The plinth 120 may be constructed of any height including but not limited to 2, 4, 6, 8, 10, and 12 inches. For example, the plinth 120 may have a height of six inches. For instance, the electronic equipment cabinet 100 may include a main cabinet section 124 having a height of 72 inches and a plinth 120 of six inches, resulting in the electronic equipment cabinet 100 having an over height of 78 inches. The plinth 120 and/or the main cabinet section 124 may be installed onto a concrete pad or other solid surface.

Structural finite element analysis (FEA) and FEA testing have demonstrated the areas of the electronic equipment cabinet 100 that are most important for successfully meeting the GR-487 Seismic Zone 4 requirements, particulalry when attempting to meet this requirement with a significant electronic equipment (e.g., battery or telecommunication equipment) weight. These areas may include the intersection of the shelf support channels and the floor cross brackets as well as the intersection of the floor corners with the corner brackets. Any level of unacceptable deflection and stress in these areas will propagate up the electronic equipment cabinet 100 and thus lead to damage of internal components mounted higher up the electronic equipment cabinet 100 and potentially the door disengaging from its locking system, all of which is deemed a failure. Controlling the deflection and stress in these areas is mandatory to meet the requirement. Electronic equipment cabinets 100 that have more than 2500 pounds of Battery weight will cause unacceptable levels and stress in these areas if the design fails to properly account for this excessive weight. The electronic equipment cabinet 100 uses a unique combination of re-enforcement components, mechanical fastening, and structural adhesive to minimize, or control, the deflection and stress in these areas that result from the excessive weight of the electronic equipment.

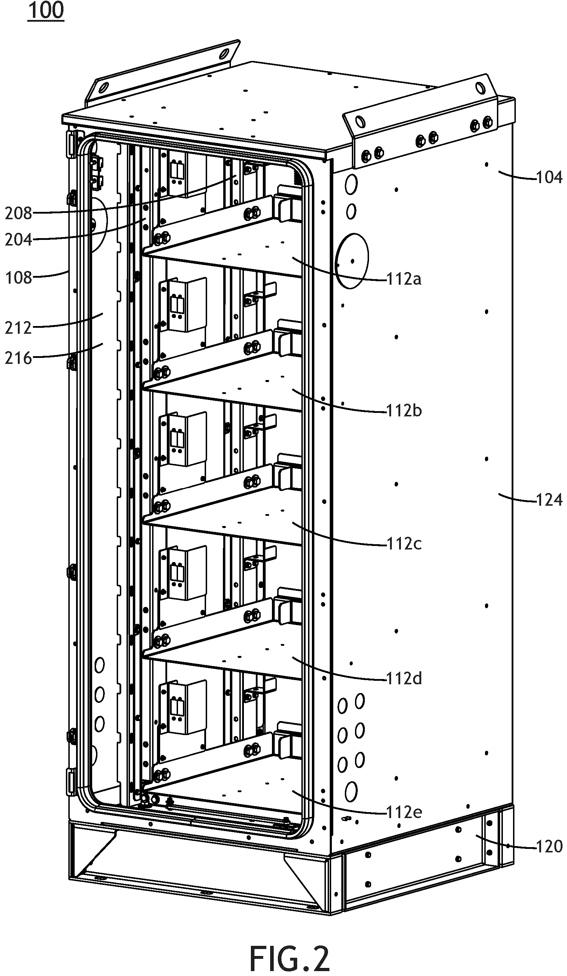

The electronic equipment cabinet 100 is shown with the battery strings 116a-e removed in FIG. 2. In examples, the electronic equipment cabinet 100 includes a left front shelf support channel 204 and left rear shelf support channel 208 disposed adjacent to, and coupled to, an inner side wall 212 of the left side panel 108 (e.g., a right front shelf support channel and a right rear shelf support channel are present but not visible in FIG. 2). The shelf support channels 204, 208 secure the shelves 112a-e to the inner side wall 212. The shelves 112a-e are secure to the shelf support channels 204, 208 via fasteners (e.g., bolts).

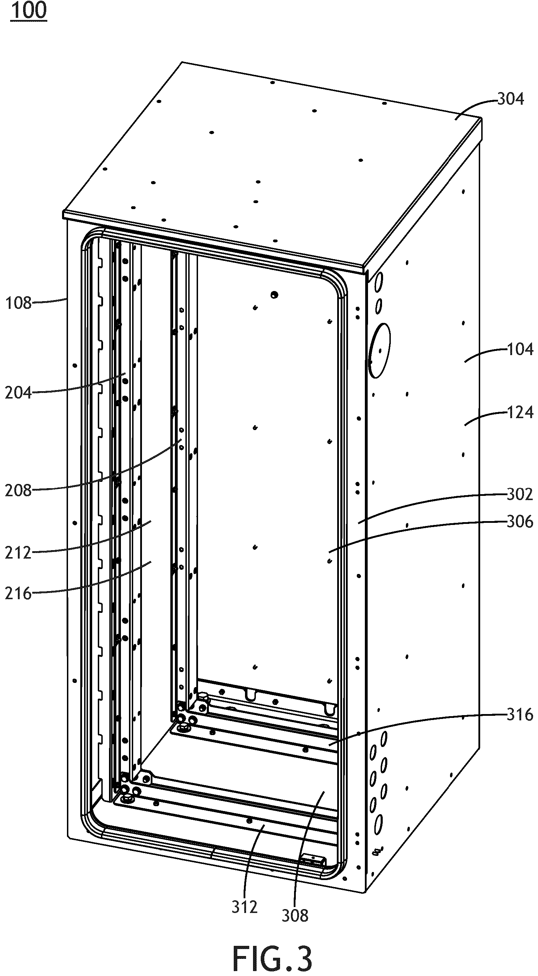

The electronic equipment cabinet 100 is shown with the battery strings 116a-e and shelves 112a-e removed in FIG. 3. In examples, the electronic equipment cabinet 100 includes a door frame 302, a top panel 304, a rear panel 306, a cabinet floor 308, and a forward floor cross bracket set 312 and rearward floor cross bracket set 316 fastened and adhered to the cabinet floor 308. The cross floor bracket sets 312, 316 are fastened to their corresponding left shelf support channels 204, 208 and right shelf support channels. In examples, the cabinet includes a door lockable to the door frame.

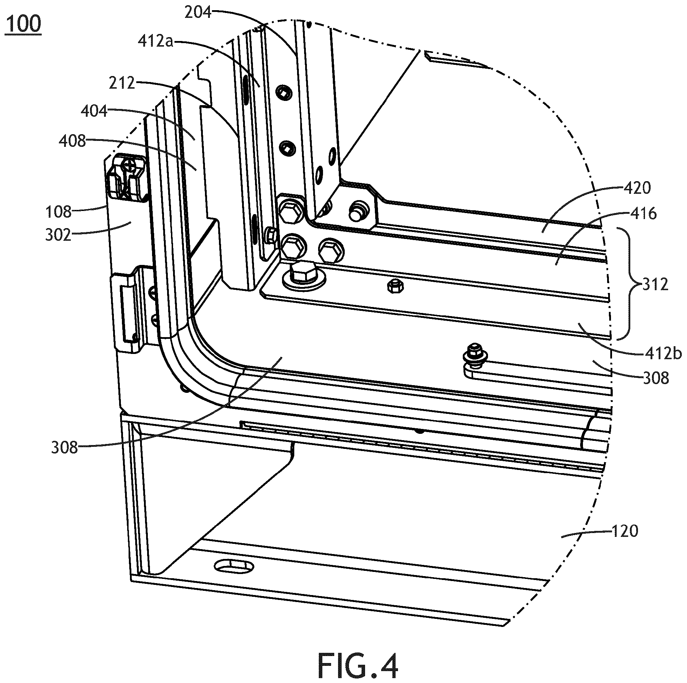

A close-up view of a lower left corner of the electronic equipment cabinet 100 is shown in FIG. 4. In examples, the electronic equipment cabinet 100 includes a left outer side wall 404 having an inside surface 408 that is coupled to the left inner side wall 212. The left shelf support channels 204, 208 are fastened to the left inner side wall 212 via fasteners and adhesive via flanges 412a that face the left inner side wall. The forward floor cross bracket set 312 may include a front cross floor bracket 416 and a rear cross floor bracket 420 coupled to the cabinet floor 308. The forward cross floor brackets 416, 420 are fastened to the cabinet floor 308 via fasteners and adhesive via flanges 412b that face the left inner side wall.

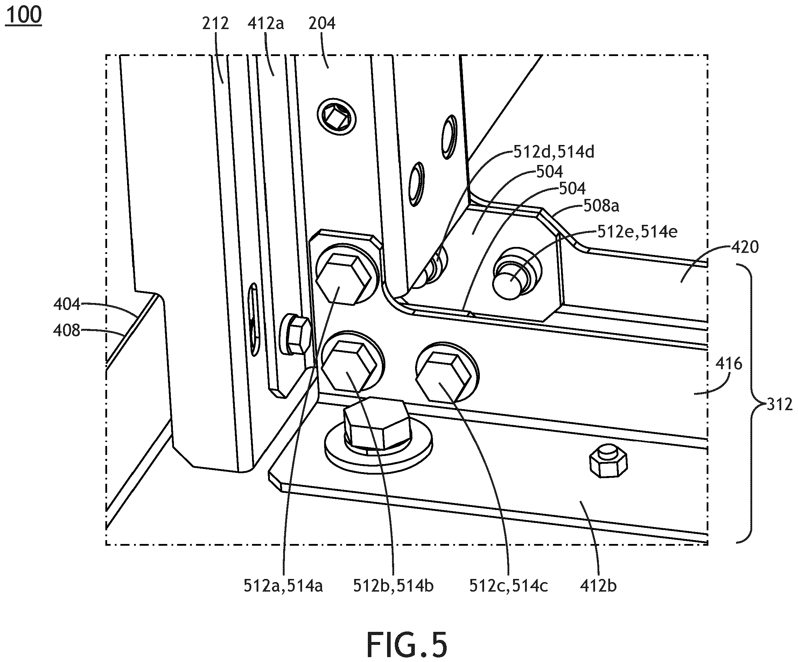

FIG. 5 illustrates a further close-up view of the lower left corner of the electronic equipment cabinet 100, particularly illustrating an intersection, or coupling, between the left front shelf support channel 204 and the forward floor cross bracket set 312. The left front shelf support channel 204 may include a channel connector 504 mateable to the bracket connectors 508a-b of the forward floor cross bracket set 312 (e.g., the front cross floor bracket 416 and the rear cross floor bracket 420). The channel connectors 504 are formed on at least a floor end 702 of the shelf support channels 204, 208. The channel connector 504 and the bracket connectors 508a-b are coupled via a set of fasteners 512a-e, inserted at respective fastener connection points 514a-e. In some examples, the floor cross bracket sets 312, 316 are constructed as a single member.

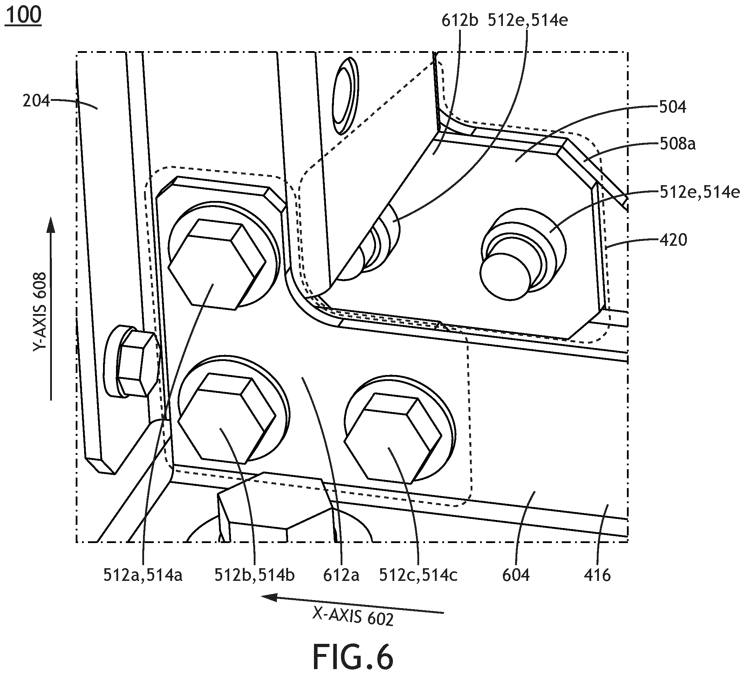

A further close-up view of the intersection or coupling between the left front shelf support channel 204 and the forward floor cross bracket set 312 is shown in FIG. 6. In examples, the bracket connectors 508 (e.g., including the bracket connectors 508a-b for the front cross floor bracket 416 and the rear cross floor bracket 420) may include at least two fastener connection points (e.g., fastener connection points 514b and 514c as shown on bracket connector 508b) that are positioned along a first direction 602 relative to the forward front floor cross bracket that are used to connect the bracket connectors 508a-b to the channel connector 504. For example, fastener connection points 514b and 514c are positioned along the first direction 602 relative to a length 604 forward front cross bracket 416 (e.g., parallel to the front cross bracket 416).

As shown in FIG. 6, the mating of the bracket connectors 508a-b and the channel connector 504 produces adherence zones 612a-b where structural adhesive is applied between the mating surfaces of the bracket connectors 508a-b and the channel connector 504. The connection between the bracket connectors 508a-b and the channel connector 504 are therefore secured with both fasteners 512a-f and structural adhesive, increasing the strength of the bond.

In examples, the bracket connectors (e.g., including the bracket connectors 508a-b for the front cross floor bracket 416 and the rear cross floor bracket 420) further include at least two fastener connection points (e.g., fastener connection points 514a and 514b as shown on bracket connector 508b) that are positioned along a second direction 608 relative to the forward front floor cross bracket. For example, fastener connection points 514a and 514b may be positioned along the second direction 608 relative to a length 604 of the forward front cross bracket 416. For instance, the fastener connection points 512a, 514b may be positioned at substantially a right angle, or 90° relative to the forward from cross bracket 416. The use of fasteners 512a-d at multiple, sequential fastener connection points 514a-d along both the first direction 602 and second direction 608 create a strong and secure intersection point along the corners along the cabinet floor 308. This coupling between the shelf support channels 204, 208 and floor cross bracket sets 312 occurs in at least four intersections along the cabinet floor 308. In examples, the top panel 304 includes cross brackets similar to the forward floor cross bracket set and coupled similarly to the shelf support channels 204, 208.

In examples, the first direction 602 and the second direction 608 are substantially at 90° relative to each other (e.g., the first direction 602 along an X-axis and the second direction 608 along a Y-axis). For example, the first direction 602 and the second direction 608 may be within 90° ± 5° (e.g., 85° to 95°) of each other. In examples, the first direction and the second direction are approximately or substantially 90° relative to each other. For example, the first direction 602 and the second direction 608 may be within 90° ± 10° of each other. In another example, the first direction 602 and the second direction 608 may be within 90° ± 20° of each other. In another example, the first direction 602 and the second direction 608i may be within 90° ± 30° of each other.

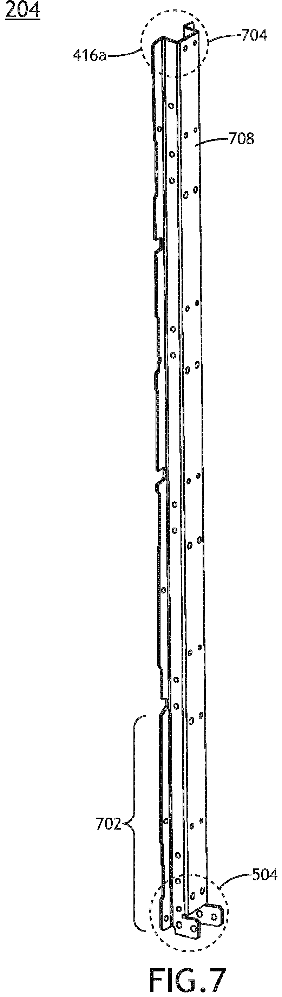

An isolated view of the left front shelf support channel 204 is shown in FIG. 7. In examples, the shelf support channels, including the left front shelf support channel 204 are constructed with a "hat" cross-section 704 that includes flanges 412a on both sides of a center section 708. The shelf support channels 204, 208, including the left front support channel 204 are constructed with a metal type and metal gauge that supports the heavy weight of the electronic equipment. For example, the shelf support channels 204, 208 may be constructed of 11-gauge steel. In another example, the shelf support channels 204, 208 may be constructed of 10-gauge steel.

The electronic equipment cabinet 100 may include a variety of fasteners 512 for construction. At points of moderate to high stress, high stress fasteners 512 may be used. For example, and in examples, M6 fasteners (e.g., bolts) are used to secure the flanges 412 of the shelf support channels 204, 208 to the inner side wall 212. The M6 fasteners may provide a dual function of serving both as an assembly alignment aid and providing clamping pressure between the mating surfaces so the structural adhesive sets properly to form the desired bond between the shelf support channels 204, 208 and the left inner side wall 212.

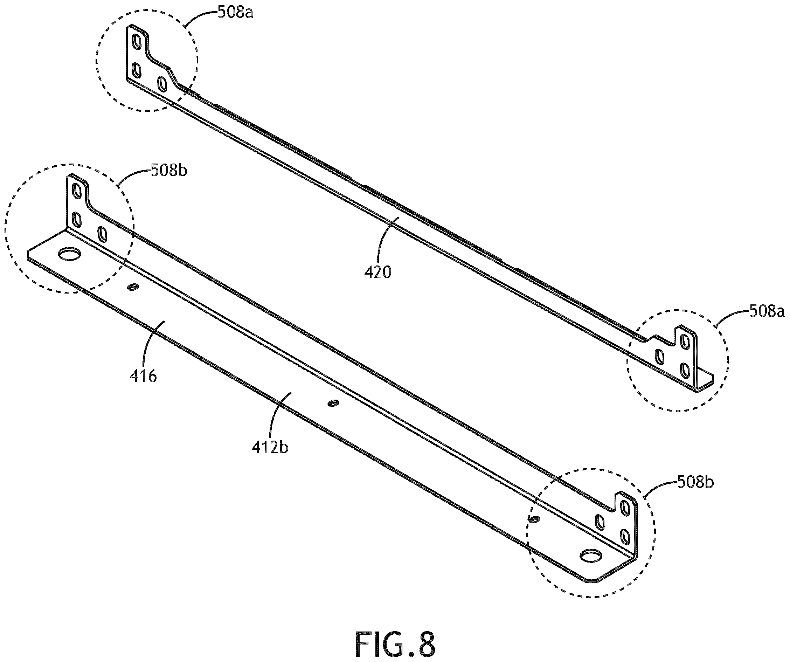

Isolated views of the front cross floor bracket 416 and the rear cross floor bracket 420 are shown in FIG. 8. In examples, the front cross floor bracket 416 and the rear cross floor bracket 420 are constructed with a "L-shape" cross-section 704 that includes a flange 412a. The front cross floor bracket 416 and the rear cross floor bracket 420 are constructed with a metal type and metal gauge that supports the heavy weight of the electronic equipment. For example, the front cross floor bracket 416 and the rear cross floor bracket 420 may be constructed of 11-gauge steel. In another example, the front cross floor bracket 416 and the rear cross floor bracket 420 may be constructed of 10-gauge steel. In examples, 3/8" mechanical fasteners, or fasteners of greater thread diameter, are used to couple the front cross floor bracket 416 and the rear cross floor bracket 420 to their respective shelf support channel 204, 208. In examples, the M6 fasteners are used to couple the front cross floor bracket 416 and the rear cross floor bracket 420 to the cabin floor 308. The front cross floor bracket 416 and the rear cross floor bracket 420 may further adhere to the cabin floor 308 via adhesives.

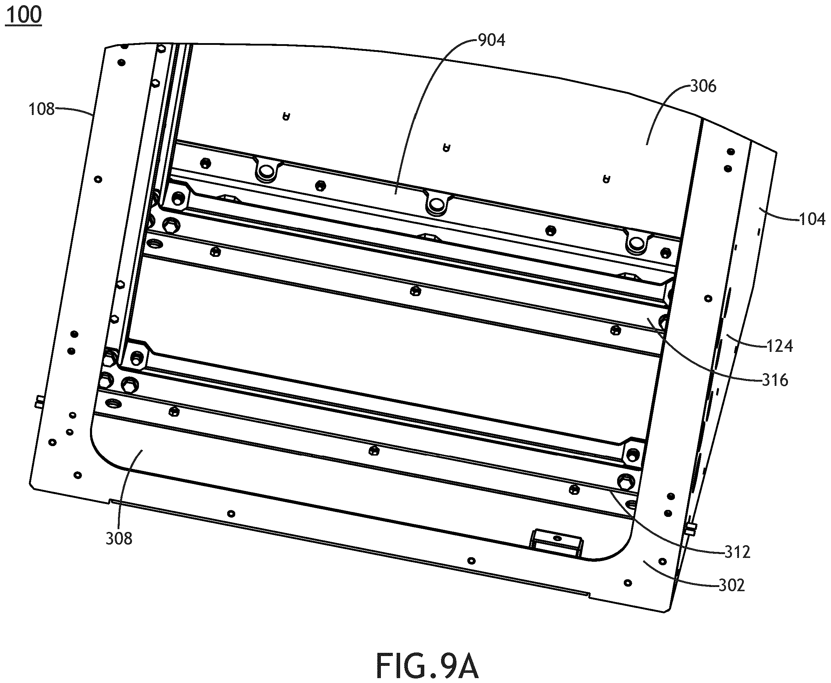

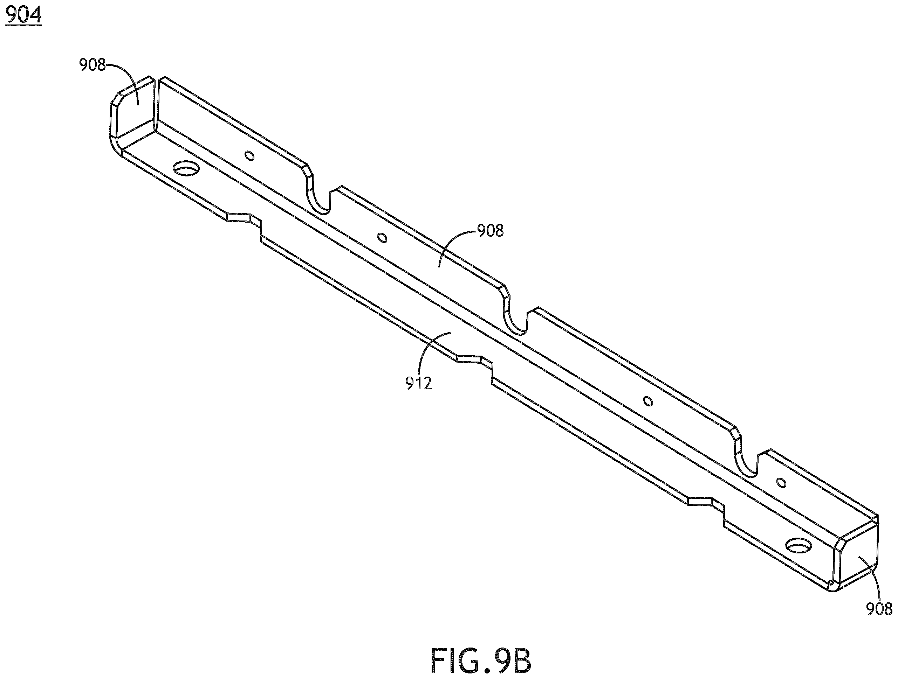

In examples, the electronic equipment cabinet 100 includes a rear stiffening bracket 904, as illustrated in FIGS. 9A and 9B. The rear stiffening bracket 904 spans an inside length of the cabinet floor 308. The rear stiffening bracket 904 may include a vertical flange 908 that couples with the rear panel 306 and the inner side walls 212. The rear stiffening bracket 904 may further include a horizontal flange 912 that couples with the cabinet floor 308. This bracket may be made of varying thicknesses of steel. For example, the bracket may be constructed from 0.250" thick steel.

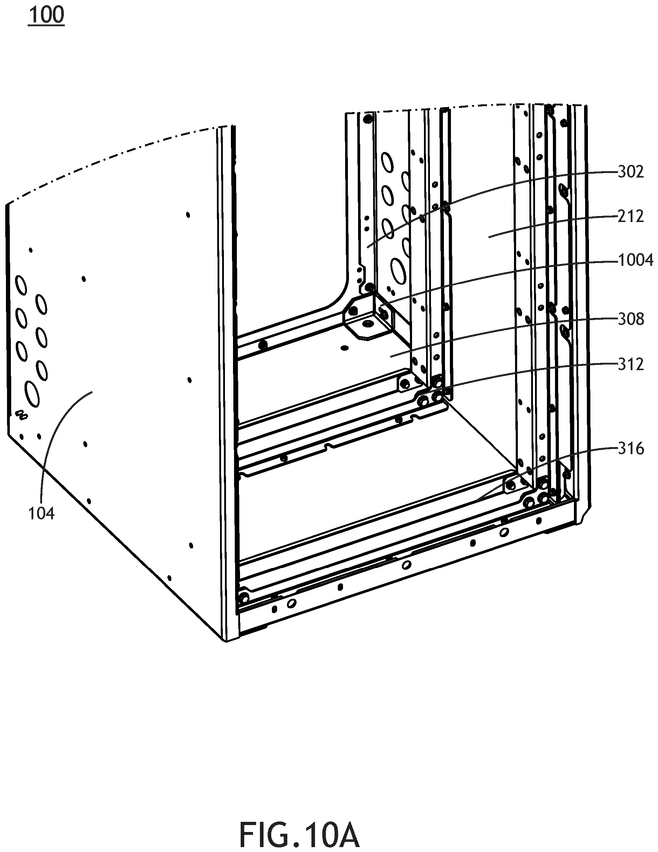

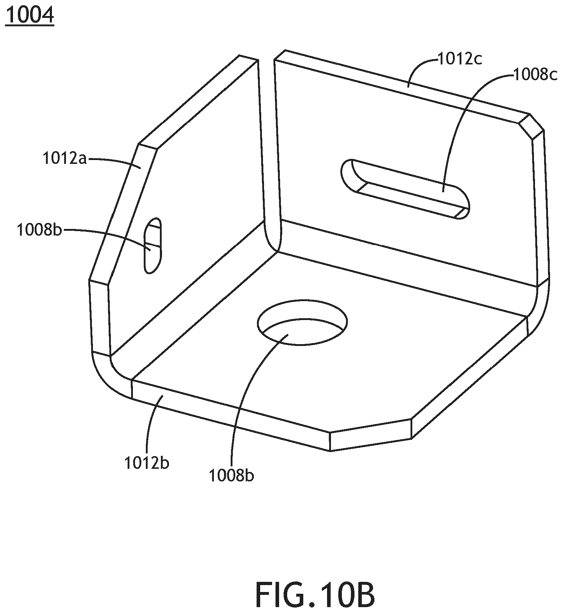

FIG. 10A illustrates a lower perspective view of the electronic equipment cabinet 100 as viewed from the back (e.g., with the rear panel 306 removed), in accordance with one or more examples of the disclosure. In examples, the electronic equipment cabinet 100 includes one or more front corner brackets 1004 that secure to a corner formed by the intersection of the cabinet floor 308, the door frame 302, and the inner side wall, such as the left inner side wall 212. The electronic equipment cabinet 100 may further include one or more rear corner brackets 1004 that secure to a corner formed by the intersection of the cabinet floor 308, the rear panel 306, and the inner side wall, such as the left inner side wall 212. The corner brackets 1004 prevent separation of components within the electronic equipment cabinet 100 during heavy load periods. A close-up perspective view of the front corner bracket 1004 is shown in FIG. 10B. The front corner bracket 1004 may include multiple fastener connection points 1008a-b for fastening the front corner bracket 1004 to the panels and sides of the electronic equipment cabinet 100. The front corner bracket 1004 may also includ surfaces 1012a-c for adhering to the panels and sides of the electronic equipment cabinet 100 via adhesives. The corner brackets 1004 may be constructed of metal. For example, the corner brackets 1004 may be constructed of steel. For example, the corner brackets 1004 may include steel brackets having a gauge thickness of 0.187" or greater.

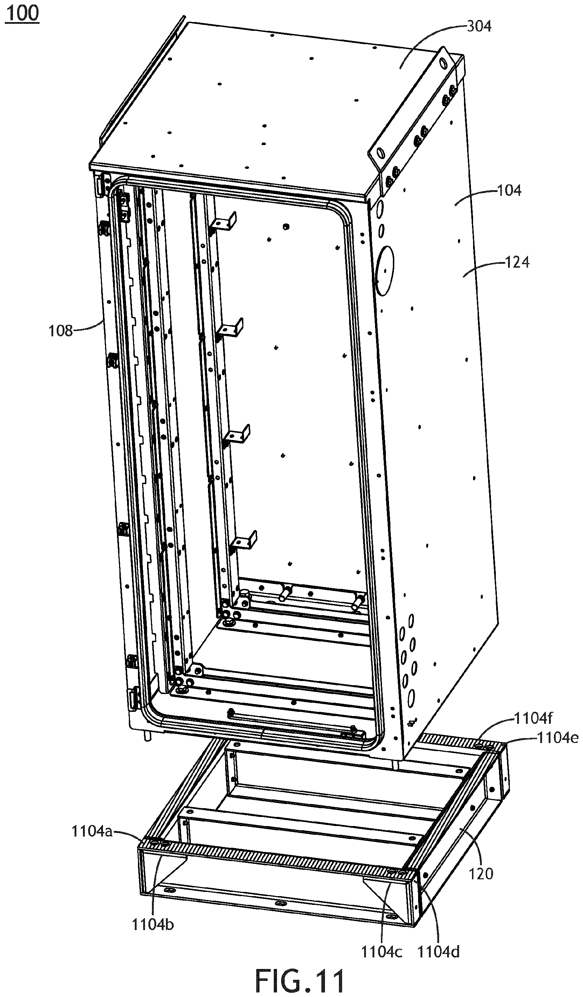

A perspective view of the electronic equipment cabinet 100 is shown in FIG. 11 with the plinth 120 separated from the main cabinet section 124. The main cabinet section 124 may attach to the plinth 120 via at least 8 mechanical fasteners 1104a-f. For example, four of the mechanical fasteners 1104a,d,e may be fastened in four corners of the plinth 120. Structural adhesive may also be used along with the fasteners 1104a-f to secure the main cabinet section 124 to the plinth 120. The plinth 120 may move with the main cabinet section 124 and may not be intended to move independently of the main cabinet section 124.

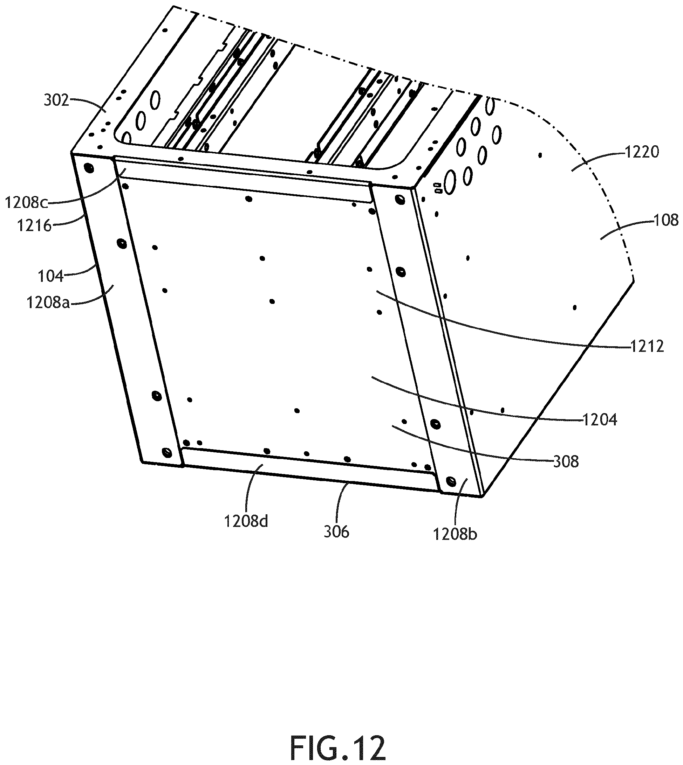

A perspective view of an underside 1204 of the main cabinet section 124 is shown in FIG. 12. In examples, the main cabinet section 124 includes one or more horizontal panel flanges 1208a-d that mate (e.g., couple or adhere) to the external surface 1212 of the cabin floor 308. For example, a portion of the left outer side wall 1216 may be folded underneath the cabin floor 308 to form a horizontal panel flange 1208a. In another example, a portion of the right outer side wall 1220 may be folded underneath the cabin floor 308 to form a horizontal panel flange 1208b. In another example, a portion of the door frame 302 may be folded underneath the cabin floor 308 to form a horizontal panel flange 1208c. In another example, a portion of the rear panel 306 may be folded underneath the cabin floor 308 to form a horizontal panel flange 1208d. Structural adhesives may be used to adhere the horizontal panel flanges 1208a-d to the external surface 1212 of the cabin floor 308.

It should be noted that structural adhesive may be used for adhering any flat surface of any component of the electronic equipment cabinet 100 to any other flat surface of any component of the electronic equipment cabinet 100 that is to be coupled. For example. As shown herein, structural adhesives may also be used to enhance the binding of surfaces that are already designed for coupling via fasteners 512. For example, structural adhesives may be used to adhere the channel connector 504 to the bracket connectors 508a-b.

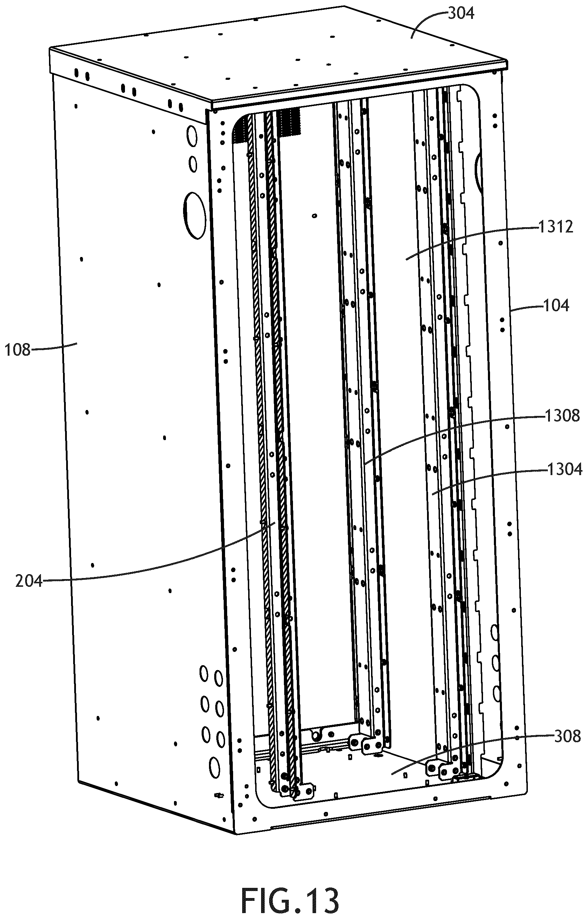

FIG. 13 illustrates a front perspective view of the main cabinet section 124, with the front left support channel 204 exploded off the left inner side wall 212. The main cabinet section 124 may include a right front shelf support channel 1304 and a right rear shelf support channel 1308 coupled to a right inner side wall 1312 and configured to support shelves 112a-e. The right front shelf support channel 1304 and the right rear shelf support channel 1308 may be similarly designed to that of the left front shelf support channel 204 and the left rear shelf support channel 208.

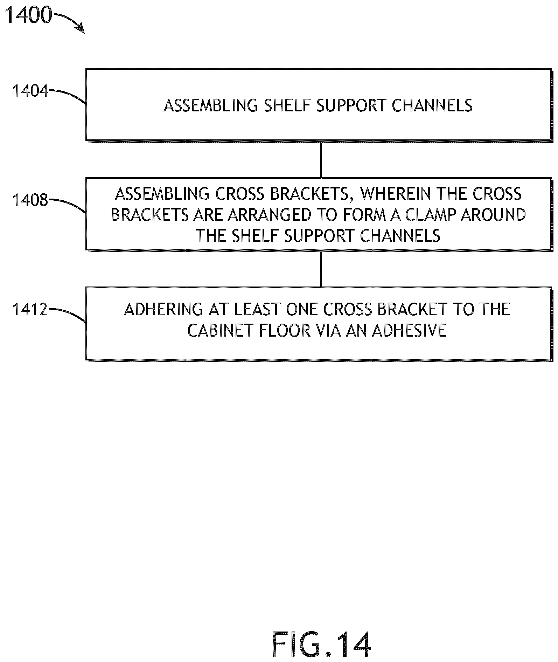

In examples, a method 1400 for constructing the electronic equipment cabinet 100 is disclosed, as illustrated in FIG. 14. The inventors have discovered a set of steps for constructing an electronic equipment cabinet 100 that satisfies GR-487 Seismic Zone 4 Requirements when the electronic equipment cabinet 100 is designed to support 2600 or more pounds of electronic equipment.

In examples, the method 1400 includes a step 1404 of assembling the shelf support channels 204, 208, 1304, 1308. For example, each of the shelf support channels 204, 208, 1304, 1308. Are fastened (e.g., via fasteners 512) to the respective inner side walls. The shelf support channels 204, 208, 1304, 1308 are also adhered to the respective inner side walls 212, 1312 via adhesive.

In examples, the method 1400 includes a step 1408 of assembling the cross brackets 416, 420. For example, the cross brackets 416, 420 may be arranged to form a rigid clamp around the shelf support channels 204, 208, 1304, 1308 at the Floor Level. For instance, the cross brackets 416, 420 may include floor mounting features (e.g., slots) that can be compressed into the shelf support channels 204, 208, 1304, 1308 assembly. In some examples, method 1400 requires the step 1408 to be performed after the step 1404. In examples, the method 1400 includes a step 1412 of adhering at least one cross bracket 416 to the cabin floor 308 via an adhesive.

It is to be understood that imagery showing cabinet componentry shown for one side (e.g., a left side) of the cabinet, infers that the other side of the cabinet (e.g., a right side) may also have similar componentry. It is to be understood that the electronic equipment cabinet 100 may include a greater number or a lesser number of specific components than those examples illustrated herein. For example, the electronic equipment cabinet 100 may include a greater number of shelf support channels 204, 208, 1304, 1308.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.
Further examples are set out in the clauses below:
1. An electronic equipment cabinet for supporting electronic equipment comprising:
   a left side panel comprising:
   a left outer side wall comprising an inside surface;
   a left inner side wall disposed adjacent to the inside surface of the left outer side wall;
   a left front shelf support channel;
   a left rear shelf support channel, wherein floor ends of the left front shelf support channel and the left rear shelf support channel comprise a channel connector, wherein the left front shelf support channel and the left rear shelf support channel are:
      fastened to the left inner side wall via fasteners; and
      adhered to the left inner side wall via an adhesive;
      a right side panel comprising a right front support channel and a right rear support channel;
      at least one shelf secured by the left front shelf support channel, the left rear shelf support channel, the right front support channel, and the right rear support channel;
      a cabinet floor;
      a forward front floor cross bracket;
      a forward rear floor cross bracket, wherein the forward front floor cross bracket and the forward rear floor cross bracket are fastened to the cabinet floor with fasteners and adhered to the cabinet floor via the adhesive, wherein each end of the forward front floor cross bracket and the forward rear floor cross bracket comprise bracket connectors, the bracket connectors comprising:
         at least two fastener connection points positioned along a first direction relative to the forward front floor cross bracket and the forward rear floor cross bracket; and
         at least two fastener connection points positioned along a second direction relative to the forward front floor cross bracket and the forward rear floor cross bracket, wherein the at least two fastener connection points positioned along the first direction and the at least two fastener connection points positioned along the second direction are couplable to a respective channel connector via the fasteners, wherein the bracket connectors and the channel connector are coupled via the fasteners and the adhesive;
         a back panel; and
         a door frame.
2. The electronic equipment cabinet of clause 1, further comprising:
   a front left corner defined by an intersection of the left inner side wall, the cabinet floor, and the door frame; and
   a front corner bracket configured to secure to the intersection and couplable to the left inner side wall, the cabinet floor, and the door frame via the fasteners.
3. The electronic equipment cabinet of clause 1 or 2, wherein the electronic equipment cabinet is configured to support 2600 pounds (1180 kilograms) of electronic equipment.
4. The electronic equipment cabinet of any one of the preceding clauses, wherein the electronic equipment cabinet is configured to pass a mechanical test in accordance with section 4.4.1.2 of Telcordia GR-63.
5. The electronic equipment cabinet of any one of the preceding clauses, wherein the electronic equipment cabinet comprises at least 21 inches of width, 22 inches of depth, and 13 inches of height.
6. The electronic equipment cabinet of any one of clauses 1-4, wherein the electronic equipment cabinet comprises at least 32 inches of width, 32 inches of depth, and 60 inches of height.
7. The electronic equipment cabinet of any one of the preceding clauses, further including a lockable door couplable to the door frame.
8. The electronic equipment cabinet of any one of the preceding clauses, wherein the first direction and the second direction are substantially at 90° relative to each other.
9. The electronic equipment cabinet of any one of the preceding clauses, wherein the at least one shelf is configured to store a battery string.
10. An electronic equipment cabinet for supporting electronic equipment comprising:
   a left side panel comprising:
   a left outer side wall comprising an inside surface;
   a left inner side wall disposed adjacent to the inside surface of the left outer side wall;
   a left front shelf support channel;
   a left rear shelf support channel, wherein floor ends of the left front shelf support channel and the left rear shelf support channel comprise a channel connector, wherein the left front shelf support channel and the left rear shelf support channel are fastened to the left inner side wall via fasteners;
   a right side panel comprising a right front support channel and a right rear support channel;
   at least one shelf secured by the left front shelf support channel, the left rear shelf support channel, the right front support channel, and the right rear support channel;
   a cabinet floor;
   a forward front floor cross bracket; and
   a forward rear floor cross bracket, wherein the forward front floor cross bracket and the forward rear floor cross bracket are fastened to the cabinet floor via fasteners, wherein each end of the forward front floor cross bracket and the forward rear floor cross bracket comprise bracket connectors, the bracket connectors comprising:
      at least two fastener connection points positioned along a first direction relative to the forward front floor cross bracket and the forward rear floor cross bracket; and
      at least two fastener connection points positioned along a second direction relative to the forward front floor cross bracket and the forward rear floor cross bracket, wherein the at least two fastener connection points positioned along the first direction and the at least two fastener connection points positioned along the second direction are couplable to a respective channel connector via the fasteners, wherein the bracket connectors and the channel connector are coupled via the fasteners.
11. The electronic equipment cabinet of clause 10, wherein the left front shelf support channel and the left rear shelf support channel are adhered to the left inner side wall via an adhesive.
12. The electronic equipment cabinet of clause 10 or 11, wherein the forward front floor cross bracket and the forward rear floor cross bracket are adhered to the cabinet floor via adhesive.
13. The electronic equipment cabinet of any one of clauses 10-12, wherein the bracket connectors and the channel connector are further coupled via an adhesive.
14. The electronic equipment cabinet of any one of clauses 10-13, wherein the electronic equipment cabinet is configured to support 2600 pounds (1180 kilograms) of electronic equipment.
15. The electronic equipment cabinet of any one of clauses 10-14, wherein the electronic equipment cabinet is configured to pass a mechanical test in accordance with section 4.4.1.2 of Telcordia GR-63.
16. The electronic equipment cabinet of any one of clauses 10-15, wherein the electronic equipment cabinet comprises at least 21 inches of width, 22 inches of depth, and 13 inches of height.
17. The electronic equipment cabinet of any one of clauses 10-15, wherein the electronic equipment cabinet comprises at least 32 inches of width, 32 inches of depth, and 60 inches of height.
18. The electronic equipment cabinet of any one of clauses 10-17, further comprising:
   a door frame; and
   a lockable door couplable to the door frame.
19. The electronic equipment cabinet of any one of clauses 10-18, wherein the first direction and the second direction are substantially at 90° relative to each other.
20. A method for constructing an electronic equipment cabinet comprising:
   assembling shelf support channels to inner side walls of the electronic equipment cabinet;
   assembling cross brackets, wherein the cross brackets are arranged to form a clamp around the shelf support channels; and
   adhering at least one cross bracket to a cabinet floor via an adhesive.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the scope of the subject matter described herein. Furthermore, it is to be understood that the invention is defined by the appended claims.

## Claims

1. . An electronic equipment cabinet for supporting electronic equipment comprising:
a left side panel comprising:
a left outer side wall comprising an inside surface;
a left inner side wall disposed adjacent to the inside surface of the left outer side wall;
a left front shelf support channel;
a left rear shelf support channel, wherein floor ends of the left front shelf support channel and the left rear shelf support channel comprise a channel connector, wherein the left front shelf support channel and the left rear shelf support channel are fastened to the left inner side wall via fasteners;
a right side panel comprising a right front support channel and a right rear support channel;
at least one shelf secured by the left front shelf support channel, the left rear shelf support channel, the right front support channel, and the right rear support channel;
a cabinet floor;
a forward front floor cross bracket; and
a forward rear floor cross bracket, wherein the forward front floor cross bracket and the forward rear floor cross bracket are fastened to the cabinet floor via fasteners, wherein each end of the forward front floor cross bracket and the forward rear floor cross bracket comprise bracket connectors, the bracket connectors comprising:
at least two fastener connection points positioned along a first direction relative to the forward front floor cross bracket and the forward rear floor cross bracket; and
at least two fastener connection points positioned along a second direction relative to the forward front floor cross bracket and the forward rear floor cross bracket, wherein the at least two fastener connection points positioned along the first direction and the at least two fastener connection points positioned along the second direction are couplable to a respective channel connector via the fasteners, wherein the bracket connectors and the channel connector are coupled via the fasteners.

2. . The electronic equipment cabinet of claim 1, wherein the left front shelf support channel and the left rear shelf support channel are adhered to the left inner side wall via an adhesive.

3. . The electronic equipment cabinet of claim 1 or 2, wherein the forward front floor cross bracket and the forward rear floor cross bracket are adhered to the cabinet floor via adhesive; or optionally
wherein the bracket connectors and the channel connector are further coupled via an adhesive.

4. . The electronic equipment cabinet of any one of the preceding claims, wherein the electronic equipment cabinet is configured to support 2600 pounds (1180 kilograms) of electronic equipment.

5. . The electronic equipment cabinet of claim 4, wherein the electronic equipment cabinet is configured to pass a mechanical test in accordance with section 4.4.1.2 of Telcordia GR-63.

6. . The electronic equipment cabinet of any one of the preceding claims, wherein the electronic equipment cabinet comprises at least 21 inches of width, 22 inches of depth, and 13 inches of height.

7. . The electronic equipment cabinet of any one of claims 1-5, wherein the electronic equipment cabinet comprises at least 32 inches of width, 32 inches of depth, and 60 inches of height.

8. . The electronic equipment cabinet of any one of the preceding claims, further comprising:
a door frame; and
a lockable door couplable to the door frame; or optionally
wherein the first direction and the second direction are substantially at 90° relative to each other.

9. . The electronic equipment cabinet of clam 1, wherein the left front shelf support channel and the left rear shelf support channel are adhered to the left inner side wall via an adhesive;
wherein the forward front floor cross bracket and the forward rear floor cross bracket are further fastened to the cabinet floor via the adhesive,
wherein the bracket connectors and the channel connector are further coupled via the adhesive; and further comprising
a back panel; and
a door frame.

10. . The electronic equipment cabinet of claim 9, further comprising:
a front left corner defined by an intersection of the left inner side wall, the cabinet floor, and the door frame; and
a front corner bracket configured to secure to the intersection and couplable to the left inner side wall, the cabinet floor, and the door frame via the fasteners; or optionally
wherein the electronic equipment cabinet is configured to support 2600 pounds (1180 kilograms) of electronic equipment.

11. . The electronic equipment cabinet of any one of claims 9-10, wherein the electronic equipment cabinet is configured to pass a mechanical test in accordance with section 4.4.1.2 of Telcordia GR-63.

12. . The electronic equipment cabinet of any one of claims 9-11, wherein the electronic equipment cabinet comprises at least 21 inches of width, 22 inches of depth, and 13 inches of height; or optionally
wherein the electronic equipment cabinet comprises at least 32 inches of width, 32 inches of depth, and 60 inches of height.

13. . The electronic equipment cabinet of any one of claims 9-12, further including a lockable door couplable to the door frame.

14. . The electronic equipment cabinet of any one of claims 9-13, wherein the first direction and the second direction are substantially at 90° relative to each other; or optionally
wherein the at least one shelf is configured to store a battery string.

15. . A method for constructing an electronic equipment cabinet comprising:
assembling shelf support channels to inner side walls of the electronic equipment cabinet;
assembling cross brackets, wherein the cross brackets are arranged to form a clamp around the shelf support channels; and
adhering at least one cross bracket to a cabinet floor via an adhesive.
